# FASCICULE DE BREVET EUROPEEN

(11) **EP 1 332 511 B1**
(45) Date de publication et mention de la délivrance du brevet: **06.05.2004**
(21) Numéro de dépôt: 01982534.8
(22) Date de dépôt: 23.10.2001
(51) Int. Cl.: H01J 37/32, H05H 1/30

(54) **DISPOSITIF DE TRAITEMENT DE GAZ PAR PLASMA**
VORRICHTUNG ZUR PLASMA-GASBEHANDLUNG
DEVICE FOR TREATING GAS WITH PLASMA

(30) Priorité: 27.10.2000 FR 0013840
(43) Date de publication de la demande: 06.08.2003
(73) Titulaire: L'AIR LIQUIDE, Société Anonyme à Directoire et Conseil de Surveillance pour l'Etude et l'Exploitation des, 75321 Paris Cédex 07 (FR)
(72) Inventeur: MOISAN, Michel, Montreal, Quebec H2V 2Z1 (CA); ZAKRZEWSKI, Zenon, PL-80-461 Gdansk (PL); KEROACK, Danielle, St. Jean sur Richelieu, Quebec J3B 1M3 (CA); ROSTAING, Jean-Christophe, 78000 Versailles (FR)
(74) Mandataire: Vesin, Jacques
(86) Numéro de dépôt international: PCT/FR2001/003293
(87) Numéro de publication internationale: WO 2002/035575

(56) Documents cités:
- EP-A- 0 104 109
- EP-A- 1 014 761
- FR-A- 2 757 082
- BARDOS L ET AL: "MICROWAVE SURFATRON SYSTEM FOR PLASMA PROCESSING" JOURNAL OF VACUUM SCIENCE AND TECHNOLOGY: PART A,US,AMERICAN INSTITUTE OF PHYSICS. NEW YORK, vol. 14, no. 2, 1 mars 1996 (1996-03-01), pages 474-477, XP000620528 ISSN: 0734-2101
- MOISAN M ET AL: "An atmospheric pressure waveguide-fed microwave plasma torch: the TIA design" PLASMA SOURCES, SCIENCE AND TECHNOLOGY, NOV. 1994, UK, vol. 3, no. 4, pages 584-592, XP001009578 ISSN: 0963-0252 cité dans la demande
- DATABASE WPI Section Ch, Week 199436 Derwent Publications Ltd., London, GB; Class L03, AN 1994-292694 XP002171377 & SE 500 740 B (BARDOS L), 22 août 1994 (1994-08-22)
- MOISAN M ET AL: "THE WAVEGUIDE SURFATRON: A HIGH POWER SURFACE-WAVE LAUNCHER TO SUSTAIN LARGE-DIAMETER DENSE PLASMA COLUMNS" JOURNAL OF PHYSICS E. SCIENTIFIC INSTRUMENTS,GB,IOP PUBLISHING, BRISTOL, vol. 20, 1987, pages 1356-1361, XP002060541 ISSN: 0022-3735

## Description

La présente invention est relative à un dispositif de traitement de gaz par plasma, dans lequel le gaz à traiter est excité par le plasma.

Les dispositifs de traitement de gaz par plasma, notamment entretenu par micro-ondes de ce type comportent généralement une structure creuse formant guide d'ondes destinée à être raccordée à un générateur de micro-ondes et des moyens pour faire circuler le gaz à traiter à travers ladite structure dans une zone dans laquelle l'amplitude du champ électrique associé à l'onde incidente est élevée, et est de préférence maximale.

Le principe de ces techniques de traitement des gaz consiste à créer au moyen d'une décharge électrique dans un gaz plasmagène majoritaire (argon, azote, krypton, xénon, etc...) contenant des impuretés ou des effluents gazeux, un plasma au sein duquel les molécules initiales sont excitées, ionisées et dissociées en fragments plus petits, atomes et radicaux. Ensuite, ces derniers se recombinent et réagissent entre eux et/ou avec des gaz auxiliaires pour donner de nouvelles espèces qui peuvent être retirées du gaz par des méthodes classiques comme par exemple l'adsorption réactive. Les molécules du gaz de fond à épurer ou à dépolluer, se retrouvent à la sortie de l'installation inchangées et dans leur état fondamental. Pour plus de détails sur les différents dispositifs permettant de créer des plasmas excités, on pourra se référer plus en détails à l'ouvrage intitulé « Microwave Excited Plasmas » de M. Moisan et J. Pelletier, Elsevier, 1992.

Le document US-A-5,750,823 décrit un dispositif de traitement de gaz par plasma qui permet d'exciter le gaz en entretenant dans celui-ci une décharge électrique au moyen d'un champ électrique associé à des ondes électromagnétiques incidentes. Celles-ci sont excitées par un applicateur de champ, formé par la structure creuse formant guide d'ondes, et qui est lui-même alimenté en puissance micro-ondes à partir d'un guide d'ondes classique, également formé par la structure creuse.

Dans le cas où le plasma est entretenu par une onde électromagnétique de surface, les applicateurs de champ utilisés sont de type surfatron-guide ou surfa-guide.

Les moyens utilisés pour faire circuler le gaz sont constitués par un tube en matériau diélectrique, dans lequel est créée la décharge.

D'autres exemples de tels systèmes de traitement de gaz sont décrits dans les documents DE-A-44 28 418 et US-A-5,300,202. Ces systèmes sont exploités à basse pression. Le document EP-A-0 295 083 décrit un dispositif de traitement de gaz par plasma comprenant une cavité résonnante opérant à pression atmosphérique.

Ces dispositifs de traitement de gaz, bien qu'avantageux en termes de rendement de conversion, d'efficacité énergétique, et de faible sensibilité de fonctionnement à des conditions opératoires variables, présentent un inconvénient majeur dans la mesure où ils sont peu ou mal adaptés au traitement de gaz dont la décomposition donne en quantité notable des matériaux solides, généralement sous forme de poudre.

Ces matériaux peuvent en effet engendrer un bouchage du tube dans lequel circule le gaz à traiter et dans lequel est créée la décharge ou, pour le moins, modifier sa géométrie interne, initialement optimisée, perturber les échanges thermiques et gêner le refroidissement du tube, ou encore altérer les propriétés diélectriques de ce dernier et perturber la propagation de l'onde de surface.

Pour pallier cet inconvénient, il est possible d'utiliser un dispositif de traitement de gaz dans lequel le gaz est transformé en plasma, non pas dans un espace tubulaire confiné, mais dans un volume relativement ouvert, séparé spatialement du guide d'onde. Dans ce cas, un des agencements possibles est celui d'une torche à plasma supportée et alimentée par le guide d'ondes.

En effet, une torche ne souffre d'aucun des inconvénients précités engendrés par la formation potentielle de dépôts solides, dans la mesure où le plasma ne se forme pas dans le conduit d'alimentation en gaz de la torche mais en aval de celui-ci, à l'extrémité de la buse de torche.

Pour réaliser un dispositif de traitement de gaz, l'extrémité libre de la torche, au niveau de laquelle le plasma se forme, débouche dans une enceinte qui a pour fonction principale de collecter de façon étanche les gaz après traitement dans le plasma ainsi que de recevoir les dépôts solides engendrés par le traitement. Les gaz ainsi collectés sont ensuite dirigés vers une canalisation de sortie. Ils peuvent par la suite être utilisés tels quels, ou bien subir un post-traitement, ou bien encore être rejetés à l'atmosphère.

Un exemple connu d'une telle torche à plasma à micro-ondes est la « torche à injection axiale» (TIA). Une telle torche est décrite par exemple dans l'article « An atmospheric pressure waveguide-fed microwave plasma torch » (Plasma Sources Sci. Technol. 3 (1994) p. 584 à 592), ou dans la demande de certificat d'addition FR-A-2 533 397. La torche TIA a été appliquée à la destruction de SF₆ et C₂F₆. Toutefois, son architecture est relativement sophistiquée et sa construction est assez complexe et coûteuse. De plus, il est intrinsèquement difficile de réaliser une très bonne étanchéité du circuit de gaz, ce qui est un inconvénient très sérieux dans le cas du traitement de gaz contenant des impuretés ou des effluents dont la conversion donne des gaz dangereux (par exemple des composés halogénés corrosifs), ou encore de gaz de haute valeur ajoutée (krypton, xénon). Enfin, la longueur du canal d'alimentation de la buse TIA est assez grande, ce qui peut poser des problèmes de recondensation des impuretés.

Le but de l'invention est de pallier ces inconvénients.

Elle a donc pour objet un dispositif de traitement de gaz par plasma, du type précité, caractérisé en ce que les moyens pour faire circuler le gaz comportent au moins une torche à plasma pour la production, en sortie de cette dernière, d'un plasma dans le gaz à traiter, la torche comprenant un injecteur en matériau conducteur électrique monté sur une première grande face de la structure formant guide d'ondes et s'étendant en saillie à travers un orifice ménagé dans une deuxième grande face opposée à ladite première grande face, un interstice de passage des ondes incidentes s'étendant autour de l'injecteur.

Ce dispositif peut également comporter une ou plusieurs des caractéristiques suivantes, prises isolément ou selon toutes les combinaisons techniquement possibles :
- le dispositif comporte des moyens de réglage de la position axiale de l'injecteur par rapport à la structure formant guide d'ondes ;
- les moyens de réglage sont agencés sous la forme d'un filetage ménagé sur la surface externe de l'injecteur coopérant avec un taraudage porté par la structure formant guide d'ondes ;
- l'injecteur comporte une partie extérieure sensiblement cylindrique, les moyens de réglage sont agencés sous la forme d'un dispositif de raccord à double bague fixé sur ladite première grande face de la structure, le dispositif de raccord à double bague étant traversé par l'injecteur et ladite partie cylindrique est serrée radialement sur ledit dispositif de raccord;
- la structure creuse formant guide d'ondes comporte une première extrémité destinée à être raccordée au générateur de micro-ondes, une seconde extrémité opposée destinée à être équipée de moyens de réglage d'impédance formant court-circuit et une zone dans laquelle sont prévus les moyens pour faire circuler le gaz et acheminer la puissance micro-ondes vers l'extrémité de l'injecteur ;
- ladite zone est une zone de section rétrécie ;
- ladite zone de section rétrécie comporte une partie de section constante dans laquelle sont prévus les moyens pour faire circuler le gaz, et ladite zone de section rétrécie s'étend entre deux parties de section linéairement croissante en direction des première et deuxième extrémités ;
- ladite zone est une zone de section constante qui s'étend entre lesdites deux extrémités, et le dispositif comporte en outre un adaptateur d'impédance qui transforme l'impédance électro-magnétique du système injecteur-plasma en l'impédance électro-magnétique caractéristique de la structure formant guide d'ondes ;
- l'adaptateur d'impédance est un cylindre creux en matériau bon conducteur électrique, notamment en cuivre ou en laiton, disposé coaxialement autour de l'injecteur, et s'étendant à partir de la deuxième grande face de la structure vers ladite première grande face ;
- les micro-ondes ont une fréquence sensiblement de 2,45 GHz, et le cylindre creux a une longueur comprise entre 25mm et 40mm, de préférence sensiblement de 33mm et un diamètre extérieur compris entre 20 et 30 mm, de préférence sensiblement de 25 mm ;
- l'interstice est délimité par l'orifice ménagé dans ladite grande face et le contour extérieur de l'injecteur;
- le dispositif comporte un disque annulaire monté sur ladite deuxième grande face et présentant un orifice central qui a un diamètre inférieur au diamètre de l'orifice de ladite deuxième grande face, l'interstice est délimité par l'orifice central, et une entretoise est disposée entre le disque annulaire et ladite seconde grande face espacée du bord de l'orifice central ;
- le bord de l'orifice délimitant l'interstice est de forme arrondie, notamment semi-torique ;
- l'interstice a une largeur comprise entre 1 mm et 3 mm ;
- la structure creuse comporte à au moins une de ses extrémités et de préférence à chacune d'elles, une fenêtre en matériau diélectrique, notamment en Téflon®, transparente à l'énergie micro-ondes et isolant de façon sensiblement étanche au gaz le volume interne de la structure creuse des sections du guide d'ondes s'étendant respectivement vers le générateur de micro-ondes et vers les moyens de réglage d'impédance ;
- le dispositif comporte en outre un réacteur de traitement monté sur la structure creuse formant guide d'ondes et coiffant l'extrémité libre de l'injecteur ;
- la paroi du réacteur de traitement est cylindrique et munie d'un serpentin de refroidissement en communication avec une source de fluide de refroidissement ;
- le dispositif comporte en outre des moyens de pompage de l'atmosphère régnant dans le réacteur de traitement ;
- les moyens de pompage constituent des moyens de réglage de l'écoulement sensiblement laminaire des gaz à l'emplacement du plasma ;
- ie réacteur est muni de moyens d'amorçage de plasma ;
- les moyens d'amorçage comprennent une tige filiforme en matériau électriquement conducteur, notamment en tungstène, s'étendant en direction de l'extrémité libre de l'injecteur et raccordée à une source de haute tension alternative et à basse fréquence ou à radio-fréquence, et des moyens de déplacement permettant de l'approcher ou de l'éloigner du voisinage de l'extrémité libre ;
- l'extrémité libre de l'injecteur a une forme générale extérieure cylindrique ou conique ; et
- l'extrémité libre de l'injecteur est munie d'un élément central en saillie de centrage du plasma par rapport à la sortie de l'injecteur, des orifices de passage pour le gaz s'étendant de part et d'autre de cet élément.

D'autres caractéristiques et avantages ressortiront de la description suivante, donnée uniquement à titre d'exemple, et faite en référence aux dessins annexés sur lesquels :
- la figure 1 est une vue schématique de profil d'un premier mode de réalisation d'un dispositif de traitement de gaz conforme à l'invention ;
- la figure 2 est une vue de dessus du dispositif de la figure 1 ;
- la figure 3 est une vue en coupe d'une partie du dispositif de la frgure 1 ;
- les figures 4 à 13 montrent différents modes de réalisation de l'injecteur du dispositif de la figure 1 ;
- la figure 14 est une installation de traitement de gaz utilisant un dispositif de traitement conforme à l'invention ;
- la figure 15 est une courbe montrant l'évolution de la puissance réfléchie dans le guide d'ondes en fonction de la hauteur de l'injecteur ;
- la figure 16 est une courbe montrant le taux de destruction d'un gaz au moyen du dispositif de la figure 1, en fonction de la pression régnant dans le réacteur ;
- la figure 17 est une courbe montrant l'évolution du taux de destruction d'un gaz en fonction de la puissance micro-ondes incidente pour différents débits de gaz et une dilution de 1% de ce dernier;
- la figure 18 est une vue schématique de profil d'un deuxième mode de réalisation d'un dispositif de traitement de gaz selon l'invention ; et
- la figure 19 est une vue en coupe selon la ligne XIX-XIX de la figure 18.

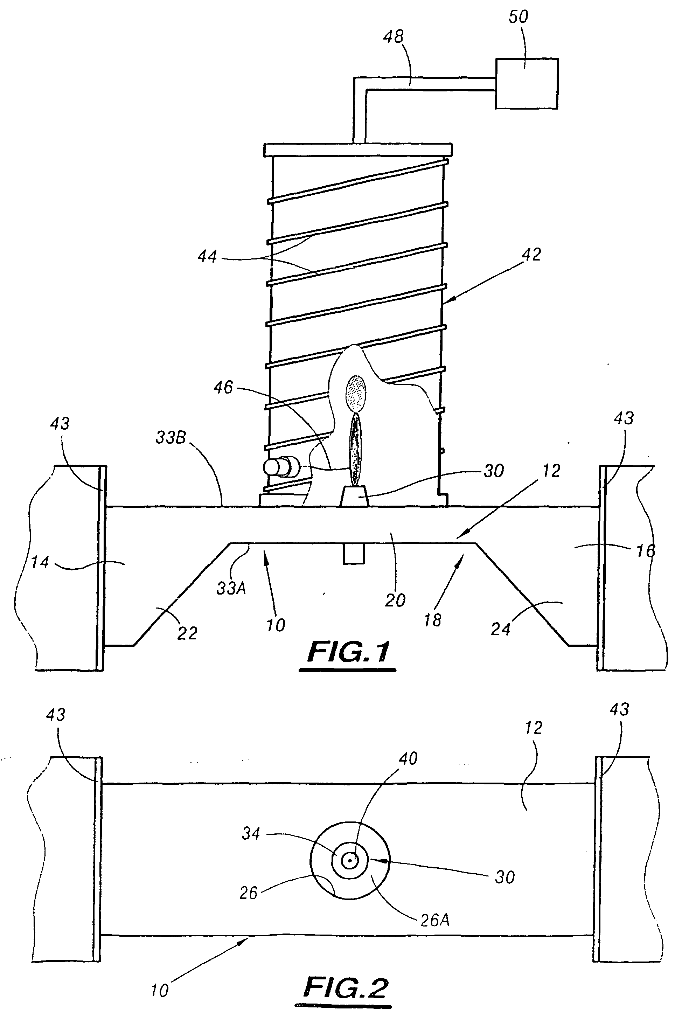

Sur les figures 1 et 2, on a représenté de façon schématique un dispositif de traitement de gaz par plasma conforme à l'invention, désigné par la référence numérique générale 10, respectivement en vue de côté et en vue de dessus.

Le dispositif 10 est principalement constitué par une structure creuse 12 formant guide d'ondes de forme longitudinale et réalisé en un matériau électriquement conducteur approprié pour l'utilisation envisagée, en particulier en métal. Elle a de préférence une section transversale rectangulaire et présente un plan de symétrie situé dans le plan de la figure 1, c'est à dire parallèle aux petites faces de la structure 12.

La structure 12 comporte deux extrémités ouvertes respectivement 14 et 16 destinées l'une à être raccordée à un générateur de micro-ondes (non représenté) et l'autre, à des moyens appropriés pour former un court-circuit ajustable, de préférence une plaque conductrice disposée transversalement et réglable longitudinalement, de manière à pouvoir procéder à un réglage d'impédance.

Entre les deux extrémités 14 et 16, la structure 12 comporte une zone 18 de section rétrécie réalisant une concentration des micro-ondes incidentes, laquelle zone 18 comporte une partie médiane 20 de section constante s'étendant entre deux parties 22 et 24 de section linéairement croissante en direction des zones d'extrémité 14 et 16.

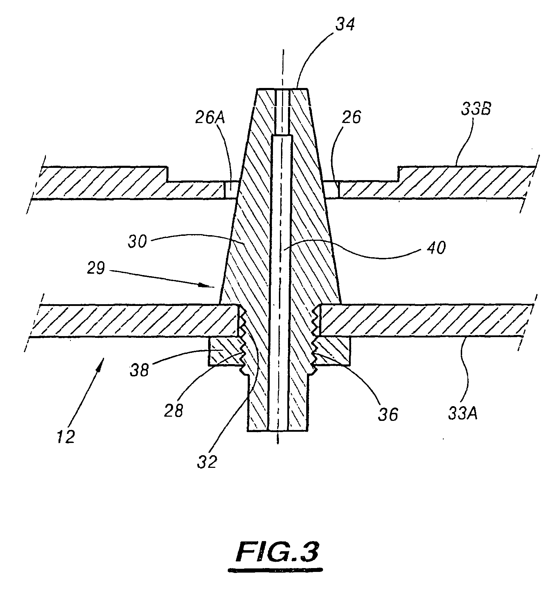

En se référant également à la figure 3, la paroi constitutive de la structure 12 comporte, au niveau de la partie médiane 20 deux orifices coaxiaux, respectivement 26 et 28, à travers lesquels s'étendent des moyens pour faire circuler un gaz à traiter à travers la structure 12 et, en particulier, à travers celle-ci dans une zone dans laquelle l'amplitude du champ électrique associée à l'onde incidente est élevée, et est de préférence maximale.

On entend par « amplitude de champ électrique élevée », une amplitude du champ électrique suffisamment élevée pour permettre un amorçage du plasma.

Comme on le voit sur cette figure 3, ces moyens sont constitués par une torche 29 supportée par le guide d'ondes, et comportant un injecteur 30 comprenant une zone proximale 32 par laquelle elle vient se fixer sur l'une des grandes faces 33A de la structure 12 et une extrémité libre distale 34 qui traverse l'orifice 26 ménagé dans la grande face opposée 33B de la structure 12 et par laquelle elle s'étend en saillie à l'extérieur de cette structure 12.

L'injecteur 30 présente une section en coupe transversale se rétrécissant en direction de son extrémité libre 34 de sorte qu'il subsiste un interstice 26A au niveau de l'orifice 26, entre l'injecteur 30 et la paroi ou face 33B constitutive de la structure 12 par lequel les ondes incidentes cheminent le long de la paroi de l'injecteur 30 en direction de l'extrémité libre 34.

Dans l'exemple de réalisation représenté sur ces figures, la structure 12 formant guide d'ondes comprend deux orifices coaxiaux 26, 28 pour le montage d'une unique torche 29. On conçoit que l'on peut prévoir un nombre supérieur de tels orifices agencés par paires d'orifices coaxiaux, pour le montage d'un nombre correspondant de torches à plasma. Dans ce cas, les paires d'orifices coaxiaux seront en général disposées de façon à, d'une part, assurer un partage égal de la puissance entre chaque interstice de manière à créer des plasmas sensiblement identiques à l'extrémité de chaque torche et, d'autre part, permettre de réaliser une bonne adaptation d'impédance de la structure à torches multiples à l'aide de moyens de réglage prévus par ailleurs (par exemple un court-circuit mobile et un adaptateur à trois vis classiques), avec une puissance réfléchie de préférence inférieure à 1 % de la puissance incidente.

Par ailleurs, le dispositif 10 comporte des moyens de réglage de la position axiale de l'injecteur 30 par rapport à la structure 12, se présentant sous la forme d'un filetage 36 ménagé dans la surface périphérique externe de la zone proximale 32 de l'injecteur et coopérant avec un taraudage d'un écrou 38 porté par la structure 12. Il est ainsi possible de régler précisément la distance entre l'extrémité libre 34 de la torche et la grande face correspondante 33B de la structure 12.

L'injecteur 30 comporte un conduit interne 40 dans lequel circule le gaz à traiter, ce conduit étant raccordé à une source d'alimentation en gaz à traiter non représentée.

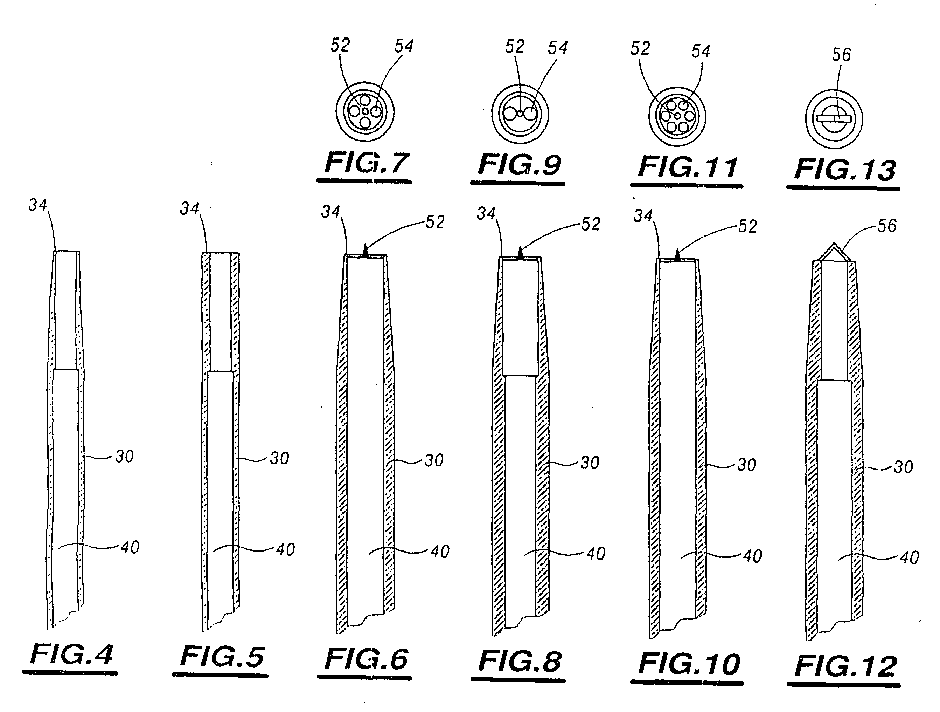

En variante, l'injecteur 30 comporte une base constituée d'un tronçon tubulaire cylindrique prolongé par une buse de forme générale extérieure cylindrique ou conique (fig. 4 à 12, et fig. 19). Le diamètre de l'orifice circulaire 26 ménagé dans la grande face du guide est adapté pour donner une largeur suffisamment petite à l'interstice circulaire 26A pour que la puissance micro-ondes soit conduite hors du guide vers la pointe de la buse. La largeur est suffisamment grande pour éviter le risque de génération d'arcs entre l'injecteur 30 et le guide d'ondes.

La largeur de l'interstice 26A est par exemple comprise entre 1 mm et 3 mm.

Le dispositif 10 comporte un réacteur de traitement 42 monté sur la structure 12 au niveau de sa zone médiane 20 de manière à coiffer l'extrémité libre de l'injecteur 30 de la torche de sorte que celle-ci débouche dans le réacteur 42.

On notera que le réacteur 42 est monté de façon étanche sur la structure 12, et communique avec le volume interne de ladite structure, par l'interstice circulaire 26A délimité par l'injecteur 30 et l'orifice 26.

Les extrémités 14, 16 de la structure sont fermées de façon étanche au gaz par deux plaques 43 en matériau diélectrique, de préférence en Téflon ®, et transparentes à l'énergie micro-ondes. Ces deux plaques 43 forment ainsi des « fenêtres » pour les micro-ondes, tandis que du gaz corrosif ou nocif éventuellement présent dans la structure 12 et venant du réacteur 42 ne peut pas circuler vers l'environnement ou vers le générateur de micro-ondes 60.

La paroi du réacteur 42 est cylindrique et est munie de moyens de refroidissement, se présentant sous la forme d'un serpentin 44 raccordé à une source de fluide de refroidissement approprié (non représentée).

Elle porte par ailleurs un organe d'amorçage de plasma agencé sous la forme d'une tige filiforme 46 conductrice, par exemple en tungstène s'étendant en direction de l'extrémité libre 34 de l'injecteur de la torche et reliée à une source de haute tension alternative à basse fréquence ou à radio-fréquence (non représentée). Cette tige 46 est munie de moyens de déplacement (non représentés) permettant de la retirer du voisinage de l'extrémité libre 34 une fois que la décharge est allumée.

Un conduit 48 est raccordé au réacteur 42 pour collecter les gaz après leur passage dans le plasma, lequel conduit est dans le présent exemple doté de moyens de pompage 50 de l'atmosphère régnant dans le réacteur.

Comme on le conçoit, le réacteur 42 permet d'isoler du milieu extérieur les gaz sortant de la torche 29 et de les collecter en totalité pour la suite du processus de traitement.

Les dimensions de la chambre du réacteur 42 doivent être suffisamment grandes pour ne pas perturber les conditions d'entretien d'un plasma que l'on veut stable et symétrique, soit par couplage parasite de l'énergie à micro-ondes aux parois de la chambre, soit par dégradation du régime d'écoulement du gaz au voisinage de la torche 29 . Cependant, les dimensions de la chambre du réacteur 42 doivent rester suffisamment faibles pour conserver une compacité à l'ensemble du dispositif.

Par exemple, le réacteur 42 est constitué par un cylindre en aluminium d'environ 200mm de diamètre et 480mm de hauteur.

Dans ce cas, les moyens de pompage 50 doivent en général être utilisés pour conserver un régime d'écoulement des gaz proche des conditions laminaires à l'emplacement de la flamme du plasma.

Bien entendu, on peut utiliser des dimensions supérieures si la compacité de l'ensemble n'est pas un inconvénient rédhibitoire.

Ainsi, dans le cas où l'on utilise un réacteur de grandes dimensions, les moyens de refroidissement peuvent être omis.

En référence aux figures 4 à 13, l'extrémité libre de l'injecteur 30 de la torche à plasma peut présenter différentes configurations.

En effet, alors que dans l'exemple de réalisation décrit schématiquement en référence aux figures 1 à 3, l'injecteur présente une forme extérieure conique, il peut également avoir une forme extérieure cylindrique comme représenté à la figure 5.

L'extrémité libre de la buse présente un diamètre compris entre 4 et 4,8mm, de préférence égal à 4mm.

Pour un diamètre supérieur, le rendement du traitement se dégrade dans la mesure où la colonne de plasma ne couvre pas toute l'ouverture.

Pour des valeurs inférieures de diamètre, l'augmentation consécutive de la vitesse du gaz à traiter diminue le temps de résidence de ses espèces dans le plasma et donc le taux de destruction.

On notera que pour un injecteur 30 à une seule ouverture, le plasma s'amorce dans une région de circonférence et se trouve donc placé de manière excentrée par rapport au flux de gaz.

Comme cela est visible sur les exemples des figures 6 à 11, l'extrémité libre de l'injecteur est dotée d'une pointe 52 centrale forçant le plasma à se fixer sur l'axe de la buse, au centre du flux de gaz.

Dans ce cas, l'extrémité libre 34 de l'injecteur comporte un ensemble d'orifices de passage de gaz, tels que 54, régulièrement répartis autour de la pointe centrale 52, par exemple au nombre de deux, quatre ou six (figures 7, 9 et 11) pour former un injecteur de type « douche ».

En variante, comme représenté sur les figures 12 et 13, la pointe centrale 52 est remplacée par une pointe 56 formant pont montée à l'extrémité libre 34 de l'injecteur.

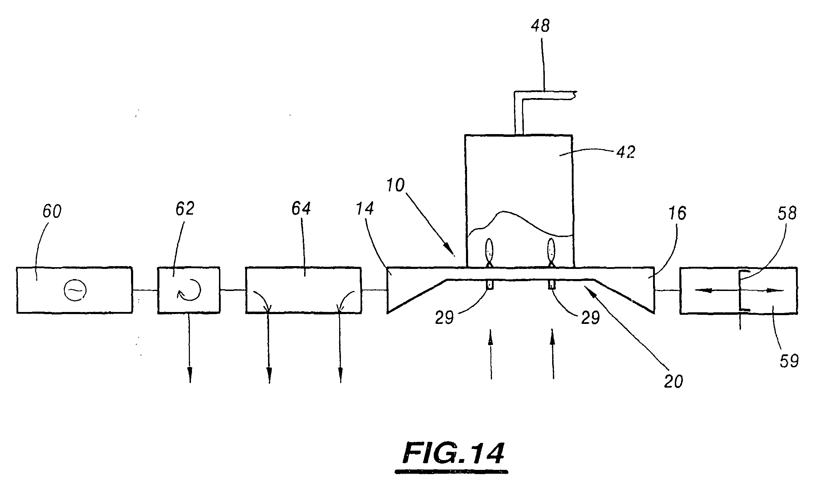

En référence à la figure 14, on va maintenant décrire une installation de traitement de gaz mettant en oeuvre le dispositif qui vient d'être décrit.

Comme on le voit sur cette figure 14, le dispositif 10 comporte deux torches 29 coiffées par un unique réacteur 42, lequel débouche dans un conduit 48 de collecte de gaz.

En variante, il est évidemment possible d'agencer un réacteur pour chaque torche individuelle.

L'une des extrémités libres 16 de la structure 12 de guide d'ondes est munie d'une plaque terminale formant court-circuit mobile 58 de réglage d'impédance raccordée à un dispositif 59 de réglage de sa position dans la structure 12.

L'extrémité opposée 14 est raccordée à un générateur de puissance 60 générant les micro-ondes incidentes par l'intermédiaire d'un circulateur 62, de type classique et optionnel, assurant une protection du générateur contre les puissances réfléchies par les torches 29 quand le plasma est éteint, ou quand l'accord d'impédance est mauvais ou en cours de réglage. Le circulateur 62 a pour rôle de transférer la puissance réfléchie vers un dispositif (non représenté) adapté pour absorber cette dernière, par exemple un dispositif muni d'une charge à eau.

Des coupleurs directionnels 64 sont par ailleurs interposés entre le circulateur 62 et le dispositif 10 de manière à prélever une fraction déterminée de la puissance passant dans le guide d'ondes, afin d'en déterminer la valeur.

L'installation est complétée par des moyens d'alimentation du dispositif 10 en gaz à traiter (non représentés) raccordés aux torches 29.

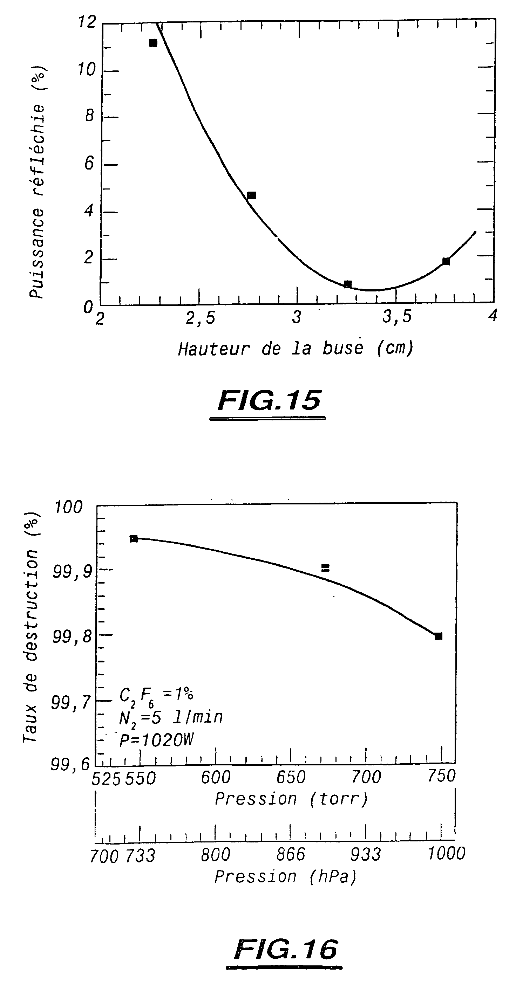

On va maintenant décrire en référence aux figures 15 à 17 un exemple d'application du dispositif de traitement qui vient d'être décrit pour la destruction de C₂F₆.

Les micro-ondes incidentes ont une fréquence de 2,45 Giga-Hertz. Le court-circuit mobile 58 monté sur l'extrémité libre 16 de la structure 12 est réglé de manière à optimiser l'accord d'impédance et minimiser la puissance réfléchie.

Il a été constaté qu'avec le dispositif à torche en guide d'ondes selon l'invention, une très faible valeur de la puissance réfléchie vers le générateur peut être obtenue après réglage du court-circuit mobile 58. Optionellement, un adaptateur d'impédance à trois vis (non représenté) peut être implanté sur le guide d'onde du côté de l'arrivée de la puissance micro-ondes, entre les coupleurs directionnels 64 et le dispositif 14 afin d'améliorer le réglage.

Par ailleurs, comme cela est visible sur la figure 15, le réglage de la position de la hauteur de l'injecteur 30 par rapport à la surface supérieure de la face 33B constitue un moyen de réglage très fin et permet de minimiser la puissance réfléchie. Dans ce présent exemple, la hauteur peut être comprise entre 2, 8 cm et 4,1 cm et est de préférence de 3, 4 cm.

La pression régnant à l'intérieur du réacteur 42 est réglée en utilisant les moyens de pompage 50 (figure 1) de manière à éviter le développement d'un arc électrique entre la buse de la torche 29 et la paroi du réacteur 42 et de façon à obtenir un plasma stable, pour une plage déterminée de puissance micro-ondes.

On notera que si la pression à l'intérieur du réacteur 42 est abaissée, la puissance des micro-ondes incidentes doit être réduite en conséquence pour maintenir une stabilité acceptable du plasma.

En référence à la figure 16, on constate que la pression régnant dans le réacteur 42 a également une influence sur le taux de destruction de C₂F₆.

Ainsi, pour maintenir une stabilité acceptable du plasma, éviter les risques d'apparition d'arcs et pouvoir maintenir un niveau de puissance suffisant pour atteindre le taux de destruction recherché, on travaille, de préférence, à des pressions comprises entre 800 hPa (600 Torr) et 866 hPa (650 Torr).

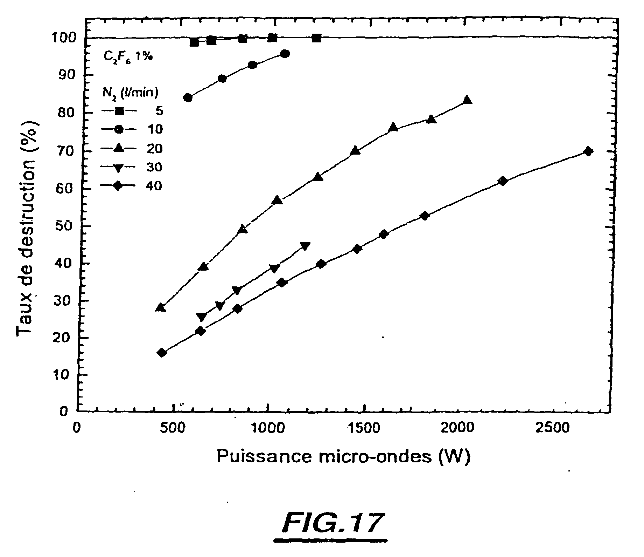

Sur la figure 17, on a représenté une courbe illustrant la variation du taux de destruction de C₂F₆ en fonction de la puissance micro-ondes incidente, pour du C₂F₆ dilué à 1% dans de l'Azote, et ce pour différents débits d'Azote. On constate, qu'à faible débit (5,0 litres par minute), le taux de destruction atteint facilement 100% pour une puissance modérée (1200 Watts). En revanche, lorsque l'on augmente le débit d'Azote à 40,0 litre par minute, même en utilisant deux torches, le taux de destruction pour une puissance comparable n'est plus que de l'ordre de 40%. Pour remonter à un taux de destruction à 70%, il faut atteindre une puissance de 2800 watts.

On conçoit dès lors à partir de ce qui précède, que les conditions opératoires du dispositif décrit en référence aux figures 1 à 13, peuvent être adaptées de manière à obtenir un taux de destruction de C₂F₆ proche de 100%, en jouant sur le débit et sur la puissance micro-ondes absorbée. Ces résultats ne sont pas affectés par la génération de matériaux solides issus de la décomposition des gaz traités, dans la mesure où le plasma est produit dans le réacteur 42, en aval de la torche 29 et non pas dans le conduit d'alimentation du dispositif en gaz à traiter.

Les résidus solides ne sont donc pas susceptibles d'induire un bouchage de ce conduit ou de modifier sa géométrie interne. Ils peuvent en outre être aisément récupérés dans la mesure où ces produits de décomposition s'accumulent dans le bas du réacteur 42.

En outre, ces performances sont obtenues au moyen d'un dispositif de traitement de gaz selon l'invention, qui est d'une structure simple, donc peu onéreuse, dans la mesure où les moyens prévus pour appliquer le champ électrique associé à l'onde électromagnétique incidente sont grandement simplifiés par rapport à ceux qui équipent généralement les torches à plasma, tout en restant d'une grande efficacité.

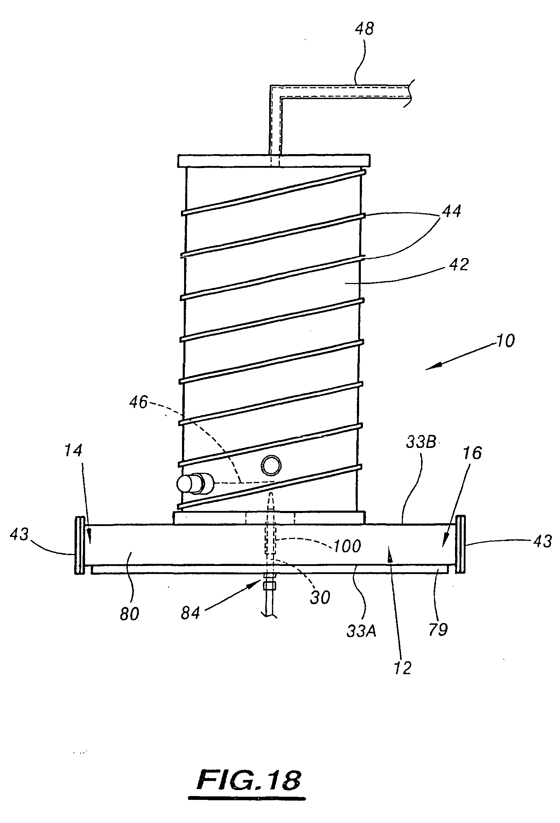

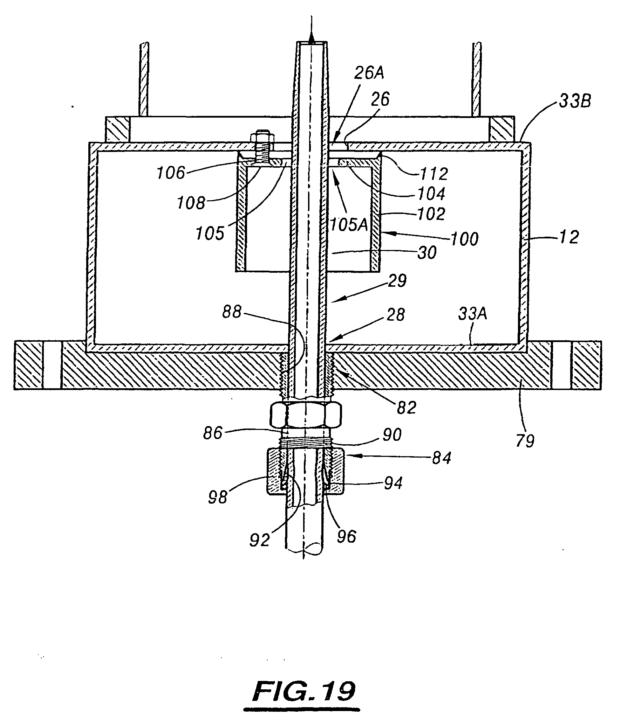

Sur les figures 18 et 19, on a représenté un second mode de réalisation d'un dispositif selon l'invention. Dans ce qui suit uniquement les différences par rapport au premier mode de réalisation seront décrites. Les éléments analogues à ceux du premier mode de réalisation portent des références identiques.

Ce dispositif 10 comporte une structure creuse 12 portée par une plaque de support 79. La structure creuse présente une zone 80 de section transversale identique sur toute sa longueur entre les deux extrémités 14, 16.

La plaque de support 79 comporte un taraudage 82 coaxial par rapport aux deux orifices 26, 28 de la structure creuse 12.

Un dispositif de raccord à double bague 84 est vissé dans ce taraudage 82 et s'étend du côté de la plaque 79 opposé à la structure creuse 12. Ce dispositif de raccord 84 est connu en soi et est commercialisé par exemple sous le nom « Swagelok ®».

Ce dispositif de raccord 84 comprend un corps de base 86 sensiblement en forme de cylindre creux.

Le corps de base 86 a un filetage extérieur 88 par lequel il est fixé dans le taraudage 82. Le corps de base 86 comporte sur le côté opposé à la plaque de support 79 un filetage extérieur 90 et une surface conique 92 intérieure qui se rétrécit vers le support.

Le dispositif 84 comprend en outre deux bagues 94, 96 de forme tronconique disposées coaxialement l'une à l'autre et par rapport au corps de base 86. La surface tronconique de la première bague 94 s'applique contre la surface tronconique 92 du corps de base 86.

Un écrou de serrage 98 est vissé sur le filetage exterieur 90 et serre la première bague 94 entre la deuxième bague 96 et le corps de base 86.

L'injecteur 30 comporte une partie cylindrique et s'étend à travers l'écrou 98, les deux bagues 94, 96 et le corps de base 86. L'injecteur 30 est fixé axialement par serrage radial de la première bague 94 contre une partie cylindrique de l'injecteur 30.

Un réglage continu de la hauteur de l'injecteur 30 par rapport à la face 33B de la structure creuse 12 est ainsi possible.

Le dispositif 10 comporte en outre un transformateur d'impédance 100 fixé sur la surface intérieure de la face opposée 33B de la structure creuse 12.

Le transformateur d'impédance 100 est essentiellement un cylindre creux 102 disposé coaxialement autour de la torche 29.

L'extrémité de ce cylindre creux 102 adjacente à la face opposée 33B comporte une base de fixation 104 en forme de disque annulaire dans laquelle est ménagée un orifice central 105 pour le passage de l'injecteur 30. Trois trous de fixation 106 (dont un est visible) sont ménagés dans la base 104 et sont répartis régulièrement autour de l'axe du cylindre. Le transformateur d'impédance 100 est fixé sur la structure creuse 12 par l'intermédiaire de trois vis 108.

Il est à noter que l'orifice central 105 de la base 104 présente un diamètre légèrement inférieur au diamètre de l'orifice 26 de la structure.

Ainsi, les deux orifices 26, 105 sont découplés sur le plan électro-magnétique et l'acheminement de la puissance micro-ondes vers l'extrémité 34 de l'injecteur 30 est, à l'emplacement des orifices 26, 105, sensiblement déterminé par l'interstice 105A présent entre l'orifice 105 et l'injecteur 30. Le bord de l'orifice central 105 est de forme arrondie, notamment semi-torique afin de diminuer le risque de génération d'arcs entre le bord et l'injecteur 30.

La base de fixation 104 comporte en outre un rebord axial 112 circulaire sur sa surface tournée vers la face opposée 33B de la structure creuse 12. Le rebord 112 a sensiblement le même diamètre que la base de fixation 104. Ce rebord 112 forme une entretoise espaçant la base de fixation 104 de la face opposée 33B et découplant ainsi le transformateur d'impédance 100 de la structure creuse 12 en ce qui concerne l'énergie micro-ondes.

De cette façon, le passage de la puissance micro-ondes vers l'emplacement de la décharge est déterminé principalement par le transformateur d'impédance 100.

Les dimensions du transformateur d'impédance sont choisies de sorte que l'impédance électro-magnétique de l'injecteur 30 soit sensiblement l'impédance électro-magnétique caractéristique de la structure creuse 12.

Le transformateur d'impédance est fabriqué par exemple en cuivre ou en laiton mais il peut être fabriqué en tout matériau bon conducteur de l'électricité. Pour une fréquence de micro-ondes de 2,45 GHz, les dimensions préférentielles du transformateur sont les suivantes: la longueur est comprise entre 30 et 40 mm, et est de préférence de 33 mm et le diamètre extérieur est compris entre 20 mm et 30 mm et est de préférence de 25 mm.

Le fonctionnement du dispositif selon le deuxième mode de réalisation est analogue au fonctionnement du dispositif selon le premier mode de réalisation.

Le deuxième mode de réalisation du dispositif selon l'invention est d'une structure particulièrement simple et a un faible coût de fabrication.

## Revendications

1. Dispositif de traitement de gaz par plasma notamment entretenu par micro-ondes, du type comprenant une structure creuse (12) formant guide d'ondes destinée à être raccordée à un générateur (60) de micro-ondes, et des moyens (29) pour faire circuler le gaz à traiter à travers ladite structure dans une zone dans laquelle l'amplitude du champ électrique associé à l'onde incidente est élevée et de préférence maximale, **caractérisé en ce que** les moyens pour faire circuler le gaz comportent au moins une torche (29) à plasma pour la production, en sortie de cette dernière, d'un plasma dans le gaz à traiter, la torche comprenant un injecteur (30) en matériau conducteur électrique monté sur une première grande face (33A) de la structure (12) formant guide d'ondes et s'étendant en saillie à travers un orifice (26) ménagé dans une deuxième grande face (33B) opposée à ladite première grande face, un interstice (26A ; 105A) de passage des ondes incidentes s'étendant autour de l'injecteur (30).

2. Dispositif selon la revendication 1, **caractérisé en ce qu'**il comporte des moyens de réglage (36, 38 ; 84) de la position axiale de l'injecteur (30) par rapport à la structure (12) formant guide d'ondes.

3. Dispositif selon la revendication 2, **caractérisé en ce que** les moyens de réglage sont agencés sous la forme d'un filetage (36) ménagé sur la surface externe de l'injecteur (30) coopérant avec un taraudage (38) porté par la structure (12) formant guide d'ondes.

4. Dispositif selon la revendication 2, **caractérisé en ce que** l'injecteur (30) comporte une partie extérieure sensiblement cylindrique, **en ce que** les moyens de réglage sont agencés sous la forme d'un dispositif de raccord à double bague (84) fixé sur ladite première grande face (33A) de la structure (12), le dispositif de raccord à double bague étant traversé par l'injecteur (30) et **en ce que** ladite partie cylindrique est serrée radialement sur ledit dispositif de raccord (84).

5. Dispositif selon l'une quelconque des revendications 1 à 4, **caractérisé en ce que** la structure creuse (12) formant guide d'ondes comporte une première extrémité (14) destinée à être raccordée au générateur (60) de micro-ondes, une seconde extrémité opposée (16) destinée à être équipée de moyens de réglage d'impédance (58) formant court-circuit et une zone (18 ;80) dans laquelle sont prévus les moyens pour faire circuler le gaz et acheminer la puissance micro-ondes vers l'extrémité de l'injecteur (30).

6. Dispositif selon la revendication 5, **caractérisé en ce que** ladite zone est une zone (18) de section rétrécie.

7. Dispositif selon la revendication 6, **caractérisé en ce que** ladite zone de section rétrécie (18) comporte une partie (20) de section constante dans laquelle sont prévus les moyens (29) pour faire circuler le gaz, et **en ce que** ladite zone de section rétrécie s'étend entre deux parties (22, 24) de section linéairement croissante en direction des première et deuxième extrémités (14, 16).

8. Dispositif selon la revendication 5, **caractérisé en ce que** ladite zone est une zone (80) de section constante qui s'étend entre lesdites deux extrémités (14, 16), et **en ce que** le dispositif comporte en outre un adaptateur d'impédance (100) qui transforme l'impédance électro-magnétique du système injecteur-plasma en l'impédance électro-magnétique caractéristique de la structure (12) formant guide d'ondes.

9. Dispositif selon la revendication 8, **caractérisé en ce que** l'adaptateur d'impédance (100) est un cylindre creux (102) en matériau bon conducteur électrique, notamment en cuivre ou en laiton, disposé coaxialement autour de l'injecteur (30), et s'étendant à partir de la deuxième grande face (33B) de la structure (12) vers ladite première grande face (33A).

10. Dispositif selon la revendication 9, **caractérisé en ce que** les micro-ondes ont une fréquence sensiblement de 2,45 GHz, et **en ce que** le cylindre creux (102) a une longueur comprise entre 25mm et 40mm, de préférence sensiblement de 33mm et un diamètre extérieur compris entre 20 et 30 mm, de préférence sensiblement de 25 mm.

11. Dispositif selon l'une quelconque des revendications précédentes, **caractérisé en ce que** l'interstice (26A) est délimité par l'orifice (26) ménagé dans ladite grande face (33B) et le contour extérieur de l'injecteur.

12. Dispositif selon l'une quelconque des revendications 1 à 10, **caractérisé en ce qu'**il comporte un disque annulaire (104) monté sur ladite deuxième grande face (33B) et présentant un orifice central (105) qui a un diamètre inférieur au diamètre de l'orifice (26) de ladite deuxième grande face (33B), **en ce que** l'interstice (105A) est délimité par l'orifice central (105), et **en ce qu'**une entretoise (112) est disposée entre le disque annulaire (104) et ladite seconde grande face (33B) espacée du bord de l'orifice central (105).

13. Dispositif selon la revendication 11 ou 12, **caractérisé en ce que** le bord de l'orifice (26 ;105) délimitant l'interstice (26A ; 105A) est de forme arrondie, notamment semi-torique.

14. Dispositif selon l'une quelconque des revendications 1 à 13, **caractérisé en ce que** l'interstice (26A ; 105A) a une largeur comprise entre 1 mm et 3 mm.

15. Dispositif selon la revendication 5 ou l'une des revendications dépendantes de la revendication 5, **caractérisé en ce que** la structure creuse (12) comporte à au moins une de ses extrémités (14, 16) et de préférence à chacune d'elles, une fenêtre (43) en matériau diélectrique, notamment en Téflon®, transparente à l'énergie micro-ondes et isolant de façon sensiblement étanche au gaz le volume interne de la structure creuse (12) des sections du guide d'ondes s'étendant respectivement vers le générateur de micro-ondes (60) et vers les moyens de réglage d'impédance (58).

16. Dispositif selon l'une quelconque des revendications 1 à 15, **caractérisé en ce qu'**il comporte en outre un réacteur (42) de traitement monté sur la structure creuse formant guide d'ondes (12) et coiffant l'extrémité libre de l'injecteur (30).

17. Dispositif selon la revendication 16, **caractérisé en ce que** la paroi du réacteur (42) de traitement est cylindrique et munie d'un serpentin (44) de refroidissement en communication avec une source de fluide de refroidissement.

18. Dispositif selon l'une quelconque des revendications 16 ou 17, **caractérisé en ce qu'**il comporte en outre des moyens (50) de pompage de l'atmosphère régnant dans le réacteur (42) de traitement.

19. Dispositif selon la revendication 18, **caractérisé en ce que** les moyens de pompage constituent des moyens de réglage de l'écoulement sensiblement laminaire des gaz à l'emplacement du plasma.

20. Dispositif selon l'une quelconque des revendications 17 à 19, **caractérisé en ce que** le réacteur (42) est muni de moyens (46) d'amorçage de plasma.

21. Dispositif selon la revendication 20, **caractérisé en ce que** les moyens d'amorçage comprennent une tige filiforme (46) en matériau électriquement conducteur, notamment en tungstène, s'étendant en direction de l'extrémité libre (34) de l'injecteur (30) et raccordée à une source de haute tension alternative et à basse fréquence ou à radio-fréquence, et des moyens de déplacement permettant de l'approcher ou de l'éloigner du voisinage de l'extrémité libre (34).

22. Dispositif selon l'une quelconque des revendications 1 à 21, **caractérisé en ce que** l'extrémité libre (34) de l'injecteur (30) a une forme générale extérieure cylindrique ou conique.

23. Dispositif selon la revendication 22, **caractérisé en ce que** l'extrémité libre (34) de l'injecteur (30) est munie d'un élément (52 ; 56) central en saillie de centrage du plasma par rapport à la sortie de l'injecteur (30), des orifices (54) de passage pour le gaz s'étendant de part et d'autre de cet élément.

## Claims

1. Device for treating gas with plasma, particularly sustained by microwaves, of the type comprising a hollow structure (12) forming a waveguide intended to be connected to a microwave generator (60) and means (29) for causing the gas for treatment to circulate through the said structure in a region in which the amplitude of the electrical field associated with the incident wave is high and preferably at a maximum, **characterized in that** the means for causing the gas to circulate comprise at least one plasma torch (29) for producing, at its outlet, a plasma in the gas for treatment, the torch comprising an injector (30) made of electrically conducting material mounted on a first large face (33A) of the waveguide-forming structure (12) and projecting through an orifice (26) made in a second large face (33B) opposite the said first large face, a gap (26A; 105A) for the passage of the incident waves extending around the injector (30).

2. Device according to Claim 1, **characterized in that** it comprises means (36, 38; 84) of adjusting the axial position of the injector (30) with respect to the waveguide-forming structure (12).

3. Device according to Claim 2, **characterized in that** the adjusting means are designed in the form of a screwthread (36) formed on the external surface of the injector (30) and collaborating with a tapping (38) borne by the waveguide-forming structure (12).

4. Device according to Claim 2, **characterized in that** the injector (30) has a roughly cylindrical outer part, **in that** the adjusting means are designed in the form of a double ring coupling device (84) fixed to the said first large face (33A) of the structure (12), the double ring coupling device having the injector (30) passing through it, and **in that** the said cylindrical part is tightened radially onto the said coupling device (84).

5. Device according to any one of Claims 1 to 4, **characterized in that** the waveguide-forming hollow structure (12) has a first end (14) intended to be connected to the microwave generator (60), an opposite second end (16) intended to be equipped with impedance adjusting means (58) forming a short circuit, and a region (18; 80) in which the means for causing the gas to circulate and for conveying the microwave power to the end of the injector (30) are provided.

6. Device according to Claim 5, **characterized in that** the said region is a region (18) of narrowed cross section.

7. Device according to Claim 6, **characterized in that** the said region (18) of narrowed cross section comprises a part (20) of constant cross section in which the means (29) for causing the gas to circulate are provided, and **in that** the said region of narrowed cross section extends between two parts (22, 24) the cross section of which increases linearly towards the first and second ends (14, 16).

8. Device according to Claim 5, **characterized in that** the said region is a region (80) of constant cross section which extends between the said two ends (14, 16), and **in that** the device further comprises an impedance matcher (100) which converts the electromagnetic impedance of the plasma injector system into the characteristic electromagnetic impedance of the waveguide-forming structure (12).

9. Device according to Claim 8, **characterized in that** the impedance matcher (100) is a hollow cylinder (102) made of a material that is a good conductor of electricity, particularly of copper or brass, arranged coaxially around the injector (30), and extending from the second large face (33B) of the structure (12) towards the said first large face (33A).

10. Device according to Claim 9, **characterized in that** the microwaves have a frequency of roughly 2.45 GHz, and **in that** the hollow cylinder (102) has a length of between 25 mm and 40 mm, preferably roughly equal to 33 mm and an outside diameter of between 20 and 30 mm, preferably roughly equal to 25 mm.

11. Device according to any one of the preceding claims, **characterized in that** the gap (26A) is delimited by the orifice (26) formed in the said large face (33B) and the outline of the injector.

12. Device according to any one of Claims 1 to 10, **characterized in that** it comprises an annular disc (104) mounted on the said second large face (33B) and having a central orifice (105) which has a diameter smaller than the diameter of the orifice (26) of the said second large face (33B), **in that** the gap (105A) is delimited by the central orifice (105), and **in that** a spacer piece (112) is placed between the annular disc (104) and the said second large face (33B) spaced away from the edge of the central orifice (105).

13. Device according to Claim 11 or 12, **characterized in that** the edge of the orifice (26; 105) delimiting the gap (26A; 105A) is of rounded, particularly semi-toric, shape.

14. Device according to any one of Claims 1 to 13, **characterized in that** the gap (26A; 105A) is between 1 mm and 3 mm wide.

15. Device according to Claim 5 or one of the claims dependent on Claim 5, **characterized in that** the hollow structure (12) has, at least at one of its ends (14, 16), and preferably at each of these ends, a window (43) made of dielectric material, particularly of Teflon®, transparent to microwave energy and isolating the internal volume of the hollow structure (12) in a roughly gastight way from the waveguide sections extending respectively towards the microwave generator (60) and towards the impedance adjusting means (58).

16. Device according to any one of Claims 1 to 15, **characterized in that** it further comprises a treatment reactor (42) mounted on the waveguide-forming hollow structure (12) and capping the free end of the injector (30).

17. Device according to Claim 16, **characterized in that** the wall of the treatment reactor (42) is cylindrical and equipped with a cooling coil (44) in communication with a source of cooling fluid.

18. Device according to either one of Claims 16 and 17, **characterized in that** it further comprises means (50) of pumping the atmosphere in the treatment reactor (42).

19. Device according to Claim 18, **characterized in that** the pumping means constitute means of adjusting the roughly laminar flow of the gases at the site of the plasma.

20. Device according to any one of Claims 17 to 19, **characterized in that** the reactor (42) is equipped with plasma-striking means (46).

21. Device according to Claim 20, **characterized in that** the striking means comprise a wirelike rod (46) made of electrically conducting material, particularly tungsten, extending towards the free end (34) of the injector (30) and connected to a source of low-frequency or radio-frequency high AC voltage, and movement means allowing it to be brought closer to or moved away from the vicinity of the free end (34).

22. Device according to any one of Claims 1 to 21, **characterized in that** the free end (34) of the injector (30) has a cylindrical or conical overall exterior shape.

23. Device according to Claim 22, **characterized in that** the free end (34) of the injector (30) is equipped with a projecting central element (52; 56) for centring the plasma with respect to the outlet of the injector (30), gas passage orifices (54) extending on each side of this element.

## Patentansprüche

1. Vorrichtung zur Behandlung von Gas mit Plasma, das insbesondere durch Mikrowellen aufrecht gehalten wird, von der Art, die eine hohle Struktur (12) umfasst, die einen Wellenleiter ausbildet, welche dazu vorgesehen ist, an einen Mikrowellengenerator (60) angeschlossen zu werden, und Einrichtungen (29), um das zu behandelnde Gas durch die Struktur hindurch in einem Bereich in Umlauf zu bringen, in welchem die Amplitude des elektrischen Feldes, das der einfallenden Welle zugeordnet ist, hoch und vorzugsweise maximal ist, **dadurch gekennzeichnet, dass** die Einrichtungen, um das Gas in Umlauf zu bringen, mindestens einen Plasmabrenner (29) zur Herstellung, beim Austritt aus diesem, eines Plasmas in dem zu behandelnden Gas umfassen, wobei der Brenner eine Einspritzdüse (30) aus elektrisch leitfähigem Material umfasst, die an einer ersten Längsseite (33A) der Struktur (12) befestigt ist, welche den Wellenleiter ausbildet, und die durch eine Öffnung (26) hervorstehend verläuft, die an einer zweiten Längsseite (33B) gegenüber der ersten Längsseite angeordnet ist, einen Durchgangsspalt (26A; 105A) der einfallenden Wellen, die sich um die Einspritzdüse (30) herum ausbreiten.

2. Vorrichtung nach Anspruch 1, **dadurch gekennzeichnet, dass** sie Regulierungseinrichtungen (36, 38; 84) der axialen Position der Einspritzdüse (30) in Bezug auf die Struktur (12), welche den Wellenleiter ausbildet, umfasst.

3. Vorrichtung nach Anspruch 2, **dadurch gekennzeichnet, dass** die Regulierungseinrichtungen in Form eines Außengewindes (36) ausgestaltet sind, das an der Außenseite der Einspritzdüse (30) angeordnet ist, und das mit einem Innengewinde (38) zusammenarbeitet, das von der Struktur (12), welche den Wellenleiter ausbildet, getragen wird.

4. Vorrichtung nach Anspruch 2, **dadurch gekennzeichnet, dass** die Einspritzdüse (30) einen äußeren Abschnitt umfasst, der im Wesentlichen zylindrisch ist, dadurch, dass die Regulierungseinrichtungen in Form einer Verbindungsvorrichtung mit Doppelring (84) ausgestaltet sind, die an der ersten Längsseite (33A) der Struktur (12) befestigt ist, wobei diese Verbindungsvorrichtung mit Doppelring von der Einspritzdüse (30) durchquert wird, und dadurch, dass der zylindrische Abschnitt radial an der Verbindungsvorrichtung (84) festgeklemmt ist.

5. Vorrichtung nach irgendeinem der Ansprüche 1 bis 4, **dadurch gekennzeichnet, dass** die hohle Struktur (12), welche den Wellenleiter ausbildet, ein erstes Ende (14) umfasst, das dazu vorgesehen ist, an den Mikrowellengenerator (60) angeschlossen zu werden, ein zweites gegenüberliegendes Ende (16), das dazu vorgesehen ist, mit den Regulierungseinrichtungen der Impedanz (58) ausgestattet zu werden, die einen Kurzschluss ausbilden, und einen Bereich (18; 80), in welchem die Einrichtungen vorgesehen sind, um das Gas in Umlauf zu bringen und die Mikrowellenleistung zu dem Ende der Einspritzdüse (30) zu führen.

6. Vorrichtung nach Anspruch 5, **dadurch gekennzeichnet, dass** der Bereich aus einem Bereich (18) mit verengtem Querschnitt besteht.

7. Vorrichtung nach Anspruch 6, **dadurch gekennzeichnet, dass** der Bereich mit verengtem Querschnitt (18) einen Abschnitt (20) mit konstantem Querschnitt umfasst, in welchem die Einrichtungen (29) vorgesehen sind, um das Gas in Umlauf bringen, und dadurch, dass der Bereich mit verengtem Querschnitt zwischen zwei Abschnitten (22, 24) mit linear ansteigendem Querschnitt in Richtung des ersten und zweiten Endes (14, 16) verläuft.

8. Vorrichtung nach Anspruch 5, **dadurch gekennzeichnet, dass** der Bereich aus einem Bereich (80) mit konstantem Querschnitt besteht, der zwischen den beiden Enden (14, 16) verläuft, und dadurch, dass die Vorrichtung außerdem einen Anpassungstransformator (100) umfasst, welcher die elektromagnetische Impedanz des Einspritzdüsensystems von Plasma an die elektromagnetische Impedanz anpasst, die für die Struktur (12), welche den Wellenleiter ausbildet, charakteristisch ist.

9. Vorrichtung nach Anspruch 8, **dadurch gekennzeichnet, dass** der Anpassungstransformator (100) aus einem Hohlzylinder (102) aus einem Material guter elektrischer Leitfähigkeit besteht, insbesondere aus Kupfer oder aus Messing, der koaxial um die Einspritzdüse (30) herum angeordnet ist, und von der zweiten Längsseite (33B) der Struktur (12) zu der ersten Längsseite (33A) verläuft.

10. Vorrichtung nach Anspruch 9, **dadurch gekennzeichnet, dass** die Mikrowellen eine Frequenz aufweisen, die im Wesentlichen bei 2,45 GHz liegt, und dadurch, dass der Hohlzylinder (102) eine Länge aufweist, die zwischen 25 mm und 40 mm, und vorzugsweise im Wesentlichen 33 mm beträgt, und einen Außendurchmesser, der zwischen 20 und 30 mm, vorzugsweise im Wesentlichen 25 mm beträgt.

11. Vorrichtung nach irgendeinem der vorhergehenden Ansprüche, **dadurch gekennzeichnet, dass** der Spalt (26A) durch die in der Längsseite (33B) angeordnete Öffnung (26) und den Außenumfang der Einspritzdüse begrenzt ist.

12. Vorrichtung nach irgendeinem der Ansprüche 1 bis 10, **dadurch gekennzeichnet, dass** sie eine ringförmige Scheibe (104) umfasst, die an der zweiten Längsseite (33B) angebracht ist und eine zentrale Öffnung aufweist (105), die einen Durchmesser aufweist, der kleiner ist als der Durchmesser der Öffnung (26) der zweiten Längsseite (33B), und dadurch, dass der Spalt (105A) durch die zentrale Öffnung (105) begrenzt ist, und dadurch, dass ein Abstandsstück (112) zwischen der ringförmigen Scheibe (104) und der zweiten Längsseite (33B) von dem Rand der zentralen Öffnung (105) beanstandet angeordnet ist.

13. Vorrichtung nach Anspruch 11 oder 12, **dadurch gekennzeichnet, dass** der Rand der Öffnung (26; 105), welcher den Spalt (26A; 105A) begrenzt, eine abgerundete, insbesondere eine halb-wulstförmige Gestalt aufweist.

14. Vorrichtung nach irgendeinem der Ansprüche 1 bis 13, **dadurch gekennzeichnet, dass** der Spalt (26A; 105A) eine Weite aufweist, die zwischen 1 mm und 3 mm liegt.

15. Vorrichtung nach Anspruch 5, oder einem der von Anspruch 5 abhängigen Ansprüche, **dadurch gekennzeichnet, dass** die hohle Struktur (12) mindestens an einem ihrer Enden (14, 16), und vorzugsweise an jedem von ihnen, ein Fenster (43) aus dielektrischem Material umfasst, insbesondere aus Teflon®, das für die Mikrowellenenergie durchlässig ist und im Wesentlichen den Innenraum der hohlen Struktur (12) gegen Abschnitte des Wellenleiters gasdicht isoliert, die jeweils in Richtung des Mikrowellengenerators (60) und in Richtung der Regulierungseinrichtungen der Impedanz (58) verlaufen.

16. Vorrichtung nach irgendeinem der Ansprüche 1 bis 15, **dadurch gekennzeichnet, dass** sie außerdem einen Behandlungsreaktor (42) umfasst, der an der hohlen Struktur befestigt ist, welche den Wellenleiter (12) ausbildet, und auf das freie Ende der Einspritzdüse (30) aufgesetzt ist.

17. Vorrichtung nach Anspruch 16, **dadurch gekennzeichnet, dass** die Wand des Behandlungsreaktors (42) zylindrisch ist, und mit einer Kühlschlange (44) versehen ist, die mit einer Kühlfluidquelle in Verbindung steht.

18. Vorrichtung nach Anspruch 16 oder 17, **dadurch gekennzeichnet, dass** sie außerdem Pumpeinrichtungen (50) der Atmosphäre, die in dem Behandlungsreaktor (42) vorherrscht, umfasst.

19. Vorrichtung nach Anspruch 18, **dadurch gekennzeichnet, dass** die Pumpeinrichtungen die Regulierungseinrichtungen der im Wesentlichen laminaren Strömung des Gases dort bilden, wo sich das Plasma befindet.

20. Vorrichtung nach irgendeinem der Ansprüche 17 bis 19, **dadurch gekennzeichnet, dass** der Reaktor (42) mit Zündungseinrichtungen (46) des Plasmas versehen ist.

21. Vorrichtung nach Anspruch 20, **dadurch gekennzeichnet, dass** die Zündungseinrichtungen einen fadenförmigen Stift (46) aus elektrisch leitfähigem Material umfassen, insbesondere aus Tungsten, der in Richtung des freien Endes (34) der Einspritzdüse (30) verläuft, und an eine Quelle hoher Wechselspannung und niedriger Frequenz oder Funkfrequenz angeschlossen ist, und Verschiebeinrichtungen, die es ermöglichen, sie der Umgebung des freien Endes (34) näher zu bringen, oder sie daraus zu entfernen.

22. Vorrichtung nach irgendeinem der Ansprüche 1 bis 21, **dadurch gekennzeichnet, dass** das freie Ende (34) der Einspritzdüse (30) eine im Allgemeinen zylindrische oder konische äußere Form aufweist.

23. Vorrichtung nach Anspruch 22, **dadurch gekennzeichnet, dass** das freie Ende (34) der Einspritzdüse (30) mit einem zentralen vorspringenden Element (52; 56) zum Zentrieren des Plasmas in Bezug auf den Ausgang der Einspritzdüse (30) versehen ist, wobei Durchgangsöffnungen (54) für das Gas auf beiden Seiten des Elementes verlaufen.
